## Europäisches Patentamt

## European Patent Office

## Office européen des brevets

(11) Numéro de publication: **0 156 659**
**B1**

(12) # FASCICULE DE BREVET EUROPÉEN

(45) Date de publication du fascicule du brevet:
**18.05.88**

(51) Int. Cl.⁴: **H 01 F 40/14,** G 01 R 15/02

(21) Numéro de dépôt: **85400174.0**

(22) Date de dépôt: **01.02.85**

(54) **Dispositif de mesure d'un courant électrique utilisant un solénoide régulier en forme de tore.**

(30) Priorité: **06.02.84 FR 8401754**

(43) Date de publication de la demande:
**02.10.85 Bulletin 85/40**

(45) Mention de la délivrance du brevet:
**18.05.88 Bulletin 88/20**

(84) Etats contractants désignés:
**DE GB SE**

(56) Documents cité:
**DE-A-1 541 858**
**GB-A-394 394**

**JOURNAL OF SCIENCE & TECHNOLOGY, vol. 37, no. 3, 1970, pages 115-120, Wembley, GB; S. SEELY: "Effect of stray flux on current transformers"**

(73) Titulaire: **Etablissement Public dit: CENTRE NATIONAL DE LA RECHERCHE SCIENTIFIQUE (CNRS), 15, Quai Anatole France, F-75007 Paris (FR)**

(72) Inventeur: **Haug, Robert, 9, avenue des Bleuets, F-91400 Orsay (FR)**
Inventeur: **He, Zhong- Jun, c/o Apparatus Res Inst. 505 Wu- ning Road, 20062- Chang- Hai (CN)**
Inventeur: **Hahn, Roger, 8 Résidence les Quinconces, F-91190 Gif- sur- Yvette (FR)**

(74) Mandataire: **Bruder, Michel, 10 rue de la Pépinière, F-75008 Paris (FR)**

## Description

La présente invention concerne un dispositif de mesure d'un courant électrique utilisant un solénoïde régulier en forme de tore.

Dans l'étude des milieux parcourus par des courants électriques, tels qu'électrolytes, plasmas, il est nécessaire de localiser les lignes de courant et de connaître leurs intensités. Un dispositif classique qui est utilisé pour mesurer un courant distribué dans l'espace et passant à travers une surface, est constitué par une ceinture dite de "Rogowski" s'appuyant sur le contour de cette surface. Cette ceinture est constituée d'un solénoïde torique bobiné avec un pas régulier et la tension qui est induite dans cette ceinture est intégrée par rapport au temps, par un intégrateur analogique ou par un fluxmètre. Le signal ainsi obtenu ou l'indication du fluxmètre est proportionnel au courant à mesurer. On peut mettre ainsi en évidence une variation temporaire du courant, résultant par exemple de son établissement ou de son interruption.

Le coefficient d'induction mutuelle entre le bobinage constituant le solénoïde torique fermé long et étroit, et une ligne de courant, traversant, à l'intérieur du solénoïde, une seule fois une surface s'appuyant sur le solénoïde, est constant tandis qu'il est nul si la ligne de courant ne coupe pas ladite surface.

Il est clair qu'un solénoïde fermé ne permet pas la mesure d'un courant continu permanent s'écoulant dans un circuit électrique puisque topologiquement le circuit électrique d'une part et le solénoïde torique fermé d'autre part ne peuvent pas passer d'une position éloignée à une position entrelacée. On peut cependant faire la mesure en utilisant un solénoïde déformable pouvant s'ouvrir sans rompre la continuité électrique. On procède alors de la façon suivante: en partant du solénoïde fermé sans courant, on l'ouvre, on entoure le courant à mesurer et on referme le solénoïde. Cette procédure n'est toutefois possible que si le courant à mesurer est fixe dans l'espace ou se déplace lentement. Dans le cas de courants distribués dans l'espace et rapidement variables cette procédure est inapplicable.

La présente invention vise à remédier à ces inconvénients en procurant un dispositif de conception particulièrement simple permettent la mesure de courants rapidement variables dans le temps et dans l'espace, sans présenter d'obstacle au déplacement de ces courants.

A cet effet ce dispositif de mesure d'un courant électrique utilisant un solénoïde à pas régulier en forme de tore est caractérisé en ce que le solénoïde torique est interrompu sur une portion de sa longueur pour former une brèche permettant le libre passage de conducteurs et/ou de lignes de courants et ce solénoïde présente, à l'une au moins de ses extrémités délimitant la brèche, un bobinage de compensation branché en série avec le solénoïde de façon que les tensions induites dans ce bobinage de compensation et dans le solénoïde s'ajoutent, le nombre total $N_c$ et la surface $S_c$ des spires du ou des bobinages de compensation satisfaisant à la relation $N_c S_c = n.S.d$ dans laquelle n est le nombre de spires du solénoïde par unité de longueur, S est la surface d'une spire du solénoïde et d est la longueur de la brèche c'est-à-dire la longueur manquante pour fermer le solénoïde.

Le dispositif de mesure de courant suivant l'invention offre l'avantage qu'il ne présente aucun obstacle à la propagation et au mouvement des lignes de courant. Par ailleurs grâce à la prévision du ou des bobinages de compensation, le coefficient d'induction mutuelle du solénoïde compensé suit une loi de variation, en fonction de la position, par rapport à la brèche dans le solénoïde, d'une ligne de courant infinie traversant le plan sur lequel s'appuie ce solénoïde, qui est très proche de la loi idéale suivant laquelle ce coefficient d'induction mutuelle a une valeur constante à l'intérieur du solénoïde et une valeur nulle à l'extérieur de celui-ci.

Le dispositif de mesure suivant l'invention peut être utilisé dans de nombreux domaines par exemple dans celui de la physique des plasmas où les courants sont rapidement variables dans le temps et l'espace, ou encore en électrotechnique dans l'étude du soufflage dans les boîtiers de disjoncteurs. Il peut être utilisé en tant que pince formant capteur d'intensité et restant en permanence ouverte. On peut également l'employer à la mesure de la répartition de courants distribués dans l'espace.

On décrira ci-après, à titre d'exemples non limitatifs, diverses formes d'exécution de la présente invention, en référence au dessin annexé sur lequel:

La figure 1 est une vue en plan schématique d'un dispositif de mesure d'un courant électrique à solénoïde pourvu de deux bobinages de compensation suivant l'invention.

La figure 2 est une vue en coupe axiale, à plus grande échelle, d'une forme d'exécution des deux extrémités en regard du solénoïde délimitant la brèche ménagée dans celui-ci.

La figure 3 est un schéma electrique d'une variante d'exécution dans laquelle les bobinages de compensation sont constitués par des bobines plates.

La figure 4 est un diagramme illustrant la variation du coefficient d'induction mutuelle en fonction de la position d'une ligne de courant infinie par rapport à la brèche formée dans le solénoïde.

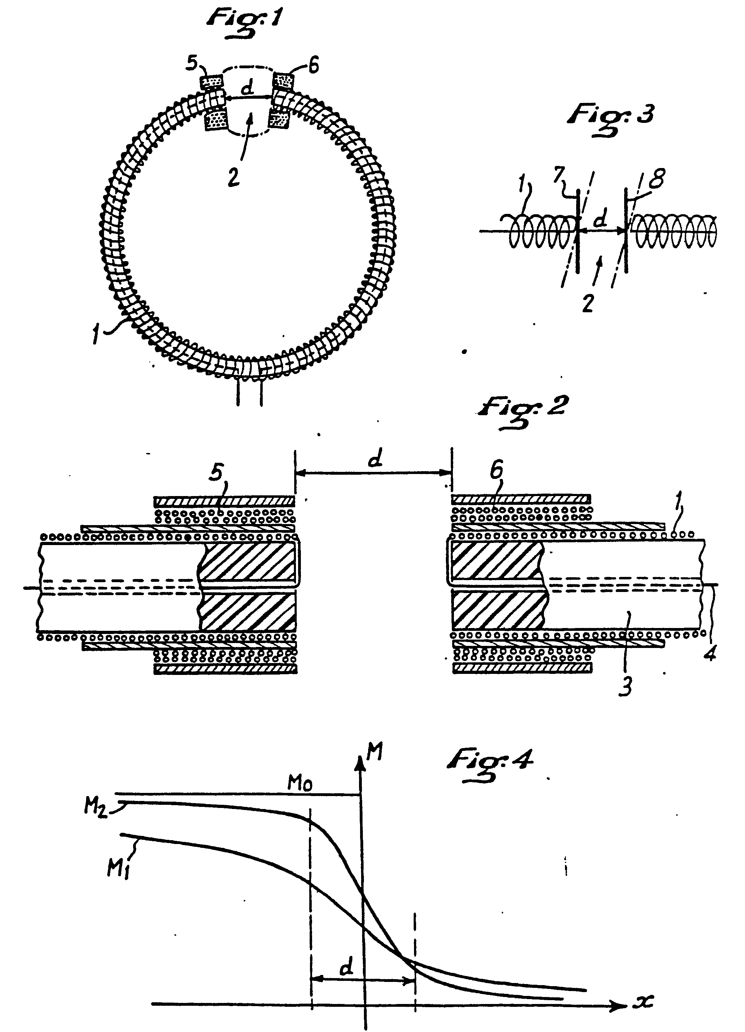

Le dispositif de mesure de courant représenté sur la figure 1 comprend un solénoïde principal 1 en forme de tore mais qui est toutefois interrompu sur une portion de sa longueur d pour délimiter, à cet endroit, un espace libre ou brèche 2. Ce solénoïde 1 peut être réalisé au moyen d'un fil fin émaillé formant des spires jointives sur une âme torique 3 constituée, par exemple par un tube de polymère souple. Le nombre $n$ de spires, par unité de longueur, du fil constituant le solénoïde principal 1 est constant tout le long du solénoïde et chacune de ces spires présente également une surface S constante. L'intérieur du tube 3 constituant l'âme du solénoïde 1 est utilisé pour le passage d'un fil conducteur 4 reliant chaque extrémité du solénoïde principal à un appareil de mesure externe (intégrateur analogique ou fluxmètre).

La brèche 2 de longueur $d$ qui est ménagée, suivant l'invention, dans le solénoïde principal constitue un passage libre permettant un libre déplacement relatif d'une ligne de courant dont l'intensité doit être mesurée et du dispositif de mesure suivant l'invention. En l'absence de la brèche 2, c'est-à-dire si le solénoïde forme un tore fermé, le coefficient d'induction mutuelle $M_0$ d'un tel solénoïde torique fermé avec un courant intérieur, c'est-à-dire une ligne de courant traversant, à l'intérieur du solénoïde 1, la surface sur laquelle ce solénoïde prend appui, a une valeur constante $M_0$, tandis que ce coefficient d'induction mutuelle est nul pour les courants extérieurs du solénoïde. La variation du coefficient d'induction mutuelle est représentée par le diagramme de la figure 4, $x$ étant défini comme étant la position, par rapport à la brèche 2, d'une ligne de courant infinie traversant le plan sur lequel s'appuie le solénoïde 1. La courbe $M_1$ illustre la variation du coefficient d'induction mutuelle dans le cas où la brèche 2 est formée dans le solénoïde 1, sans que d'autres mesures soient prises pour compenser la création de cette brèche. On voit que pour des valeurs positives de $x$, c'est-à-dire pour des courants normalement extérieurs au solénoïde 1, on a un coefficient $M_1$ non nul ce qui est gênant, car on mesure ainsi des courants éloignés de la brèche 2.

Pour remédier à cet inconvénient, suivant l'invention, on prévoit, sur l'une au moins des deux extrémités du solénoïde situées au voisinage immédiat de la brèche 2, un bobinage supplémentaire dit de compensation, lequel est connecté en série avec le solénoïde principal 1 de façon que les tensions induites dans ce solénoïde principal et dans le bobinage supplémentaire de compensation s'ajoutent.

Dans la forme d'exécution non limitative représentée sur le dessin, le dispositif de mesure comprend deux bobinages supplémentaires de compensation 5 et 6 prévus respectivement aux deux extrémités du solénoïde 1 encadrant la brèche 2. Ces deux bobinages de compensation 5, 6 qui sont branchés en série avec le solénoïde 1, sont réalisés sous une forme cylindrique et ils entourent respectivement les deux parties extrêmes du solénoïde 1 délimitant la brèche 2. Suivant une variante les bobinages de compensation pourraient être logés à l'intérieur des parties extrêmes du solénoïde 1.

Le ou les bobinages de compensation 5, 6 doivent obéir à la règle suivante: $N_cS_c = n.S.d$ où $N_c$ et $S_c$ sont respectivement le nombre et la surface des spires du ou des bobinages de compensation 5, 6, $d$ est la largeur de la brèche 2, c'est-à-dire la longueur manquante pour fermer le solénoïde principal, n et S étant respectivement le nombre et la surface des spires du solénoïde principal. Chacun des bobinages cylindriques 5, 6 peut comporter une seule couche de spires ou plusieurs couches, par exemple deux comme il est illustré dans la forme d'exécution illustrée sur la figure 2.

On peut vérifier la compensation obtenue en plaçant la brèche 2, encadrée par les bobinages de compensation 5, 6, dans un champ magnétique uniforme alternatif produit, par exemple, par une paire de bobines dites de Helmholtz. On règle alors la distance $d$ pour annuler la tension induite et la distance $d$ ainsi trouvée doit être ensuite conservée.

Grâce à la prévision des bobinages de compensation 5, 6 on obtient une loi de variation du coefficient d'induction mutuelle $M_2$ du solénoïde compensé 1 plus proche de la loi idéale, comme on peut le voir sur la figure A. La zone dans laquelle varie sensiblement le coefficient d'induction mutuelle $M_2$ est alors de l'ordre de la largeur $d$ de la brèche 2.

Les bobinages de compensation 5, 6 peuvent être réalisés de différentes manières et ils peuvent constituer des bobines plates 7, 8, ainsi qu'il est représenté sur la figure 3 ou bien encore des bobines ayant une forme de révolution quelconque. Ces bobines plates 7, 8 peuvent avoir le même axe que les extrémités du solénoïde principal 1, en s'appuyant sur deux plans parallèles délimitant l'espace libre autour de la brèche 2. Ces bobines plates 7, 8 pourraient être également inclinées par rapport à l'axe du solénoïde 1, comme il est indiqué en trait mixte sur la figure 3.

Suivant une variante les bobinages de compensation cylindriques 5, 6 ou plats 7, 8 peuvent être conçus de manière à être enfichables, mécaniquement et/ou électriquement, sur les extrémités du solénoïde principal 1. Chaque paire de bobinages cylindriques 5, 6 ou plats 7, 8 est alors adaptée à une longueur particulière $d$ de la brèche 2. Autrement dit le dispositif de mesure suivant l'invention peut être réalisé sous la forme de solénoïdes principaux présentant des longueurs de brèche $d$ différentes et à chaque longueur de brèche particulière est associée une paire de bobinages de compensation comportant un ensemble de spires présentant des caractéristiques appropriées pour assurer la compensation de l'existence de la brèche considérée.

**Revendications**

1. Dispositif de mesure d'un courant électrique utilisant un solénoïde à pas réguliers en forme de tore caractérisé en ce que le solénoïde torique (1) est interrompu sur une portion de sa longueur pour former une brèche (2) permettant le libre passage de conducteurs et/ou de lignes de courants et ce solénoïde (1) présente, à l'une au moins de ses extrémités délimitant la brèche, au moins un bobinage de compensation (5, 6) branché en série avec le solénoïde de façon que les tensions induites dans ce bobinage de compensation (5, 6) et dans le solénoïde (1) s'ajoutent, le nombre total $N_c$ et la surface $S_c$ des spires du ou des bobinages de compensation (5, 6) satisfaisant à la relation $N_cS_c = n.S.d$ dans laquelle n est la nombre de spires du solénoïde (1) par unité de longueur, S est la surface d'une spire du solénoïde (1) et d est la longueur de la brèche (2) c'est-à-dire la longueur manquante pour fermer le solénoïde (1).

2. Dispositif suivant la revendication 1 caractérisé en ce que les bobinages de compensation (5, 6) ont une forme cylindrique et ils sont enroulés à l'extérieur ou à l'intérieur des deux parties extrêmes du solénoïde délimitant la brèche (2).

3. Dispositif suivant la revendication 1 caractérisé en ce que les bobinages de compensation (7, 8) sont réalisés sous la forme de bobines plates de même axe que les parties extrêmes du solénoïde (1) ou inclinées par rapport à cet axe.

4. Dispositif suivant l'une quelconque des revendications précédentes caractérisé en ce que les bobinages de compensation (5, 6 ; 7, 8) sont amovibles et associés à une longueur (d) déterminée de la brèche (2).

5. Dispositif suivant l'une quelconque des revendications précédentes caractérisé en ce que les bobinages de compensation (5, 6 ; 7, 8) sont enfichables mécaniquement et/ou électriquement sur les extrémités du solénoïde (1).

**Claims**

1. A device for measuring an electric current using a solenoid with regular pitch in the form of a torus characterized in that the toric solenoid (1) is interrupted over a portion of its length to form a gap (2) allowing free passage of conductors and/or of lines of current and this solenoid (1) presents, at at least one of its ends defining the gap, at least one compensation coil connected in series with the solenoid so that the voltages induced in this compensation coil (5, 6) and in the solenoid (1) are added, the total number $N_c$ and the surface $S_c$ of the turns of the or each compensation coil (5, 6) statifying the relationship $N_cS_c = n.S.d.$ in which n is the number of turns of the solenoid (1) per unit of length, S is the surface of a turn of the solenoid (1) and d is the length of the gap (2), i.e. the missing length for closing the solenoid (1).

2. A device according to claim 1, characterized in that the compensation coils (5, 6) are cylindrical in form and they are wound outside or inside the two end parts of the solenoid defining the gap (2).

3. A device according to claim 1, characterized in that the compensation coils (7, 8) are made in the form of flat coils with the same axis as the end parts of the solenoid (1) or inclined with respect to this axis.

4. A device according to claim 1, characterized in that the compensation coils (5, 6 ; 7, 8) are removable and associated with a determined length (d) of the gap (2).

5. A device according to claim 1, characterized in that the compensation coils (5, 6 ; 7, 8) are mechanically and/or electrically pluggable on the ends of the solenoid (1).

**Patentansprüche**

1. Elektrische Strommeßanordnung unter Verwendung einer regelmäßigen, ringförmigen Spule, dadurch gekennzeichent, daß die ringförmige Spule (1) auf einem Teil ihrer Länge zur Bildung eines Spalts (2) unterbrochen ist, der den freien Durchtritt von Leitern und/oder Stromleitungen gestattet, und daß diese ringförmige Spule (1) an wenigstens einem ihrer den Spalt bildenden Enden wenigstens eine in Reihe mit der ringförmigen Spule geschaltete Kompensationsspule (5, 6) aufweist, derart, daß sich die in der Kompensationsspule (5, 6) und der ringförmigen Spule (1) induzierten Spannungen addieren, wobei die Gesamtzahl $N_c$ und die Oberfläche $S_c$ der Windungen der oder jeder Kompensationsspule (5, 6) der Bedingung $N_cS_c = n.S.d$ entspricht, wobei n die Zahl der Windungen der ringförmigen Spule (1) pro Längeneinheit, die Oberfläche einer Windung der ringförmigen Spule (1) und d die Länge des Spalts (2), d. h. die zum Schliessen der ringförmigen Spule (1) benötigte Länge, bezeichnet.

2. Strommeßanordnung nach Anspruch 1, dadurch gekennzeichnet, daß die Kompensationsspulen (5, 6) eine zylindrische Form aufweisen und ihre Windungen an der Außenseite oder Innenseite der beiden den Spalt (2) zwischen sich einschließenden Endabschnitte der ringförmigen Spule angeordnet sind.

3. Strommeßanordnung nach Anspruch 1, dadurch gekennzeichnet, daß die Kompensationsspulen (7, 8) als Flachspulen ausgebildet sind, die die gleiche Achse aufweisen wie die Endabschnitte der ringförmigen Spule (1) oder gegenüber dieser Achse geneigt sind.

4. Strommeßanordnung nach Anspruch 1, dadurch gekennzeichnet, daß die Kompensationsspulen (5, 6; 7, 8) abnehmbar sind und einer bestimmten Länge (d) des Spalts (2) zugeordnet sind.

5. Strommeßanordnung nach einem der vorhergehenden Ansprüche, dadurch gekennzeichnet, daß die Kompensationsspulen

**0 156 659**

(5, 6; 7,8) mechanisch und/oder elektrisch auf die
Enden der ringförmigen Spule (1) steckbar sind.

0 156 659

*Fig. 1*

*Fig. 3*

*Fig. 2*

*Fig. 4*